# EUROPÄISCHE PATENTANMELDUNG

(11) **EP 2 161 748 A2**
(43) Veröffentlichungstag der Anmeldung: **10.03.2010**
(21) Anmeldenummer: 09167725.2
(22) Anmeldetag: 12.08.2009
(51) Int. Cl.: H01L 23/498, H01L 21/607, H01L 21/48

(54) **LTCC-Substratstruktur und Verfahren zur Herstellung derselben**

(30) Priorität: 08.09.2008 DE 102008041873
(71) Anmelder: Biotronik CRM Patent AG, 6341 Baar (CH)
(72) Erfinder: Schwanke, Dieter, 95030 Hof (DE); Zeilmann, Christian, Bayreuth 95444 (DE); Krenkel, Michael, Vaihingen 71665 (DE)
(74) Vertreter: Lindner-Vogt, Karin L.

(57) **Zusammenfassung**

Die vorliegende Erfindung betrifft eine LTCC-Substratstruktur mit mindestens einem Kontaktelement zum Anschluss eines Drahtleiters, das eine erste, auf und/oder in dem keramischen Substrat angeordnete Metallisierung (20) zur elektrischen Verbindung mit dem Drahtleiter aufweist, wobei die erste Metallisierung (20) vorzugsweise Silber oder einer Silberlegierung enthält. Zur Vermeindung von Via-Posting oder eines Plattierungsprozesses sind eine die erste Metallisierung (20) überdeckende Diffusionssperrschicht (22), welche mit einem lokal wirkenden Aufbringungsverfahren hergestellt ist, und eine auf der Diffusionssperrschicht (22) angeordnete zweite Metallschicht (24) vorgesehen, wobei die zweite Metallschicht (24) vorzugsweise Gold und/oder Platin und/oder eine Legierung enthält, die mindestens eines dieser Elemente aufweist. Die Erfindung gibt außerdem ein Herstellungsverfahren für eine derartige LTCC-Substratstruktur an.

## Beschreibung

Die vorliegende Erfindung betrifft eine LTCC-Substratstruktur mit mindestens einem Kontaktelement zum Anschluss eines Drahtleiters, das eine erste, auf und/oder in dem keramischen Substrat angeordnete Metallisierung, welche vorzugsweise Silber oder einer Silberlegierung enthält, zur elektrischen Verbindung mit dem Drahtleiter aufweist sowie ein Verfahren zur Herstellung einer derartigen Substratstruktur.

Substratstukturen für Keramikleiterplatten werden heute häufig mittels der sogenannten LTCC-Technologie (LTCC = Low Temperature Cofired Ceramics, Niedertemperatur-Einbrand-Keramik) hergestellt. Diese Technologie erlaubt eine kostengünstige Herstellung von Mehrlagenschaltungen mit integrierten passiven Elementen auf der Basis von gesinterten Keramikträgern. Hierbei beschreibt der Begriff "cofired" die Möglichkeit beim LTCC-Verfahren, Leiterbahnen gemeinsam mit der Keramik zu brennen.

Zur Verbindung der Schaltungsstrukturen mittels Drahtleitern (Anschlussdrähte) sind auf dem keramischen Substrat häufig Kontaktelemente in der Form von Bondpads oder Bondinseln vorgesehen, welche aus einer Insel bestehend aus einer ersten, auf dem keramischen Substrat angeordneten Metallschicht gebildet werden. Die Drahtleiter dienen dazu, eine Schaltungsstruktur mit weiteren Schaltungsstrukturen, beispielsweise einem Halbleiterchip, elektrisch zu verbinden. Deshalb werden als Drahtleiter elektrisch gut leitende Materialien wie Gold, eine Goldlegierung, Kupfer oder eine Kupferlegierung verwendet. Das Kontaktelement wird zur Herstellung der Verbindung beispielsweise mittels Löten oder anderer Verbindungsverfahren (Bonden) mit dem Anschlussdraht verbunden.

Als Bonden (genauer: Drahtbonden) wird in der Elektrotechnik eine Verbindungstechnik bezeichnet, bei der eine Verbindung zwischen elektronischen Elementen eines elektrischen Schaltkreises mit Hilfe eines dünnen Drahtes (Drahtleiter, Anschlussdraht) durch Verschweißen des Drahts mit der Anschlussfläche erzeugt wird. Die Verschweißung kann beispielsweise mittels thermischer Aktivierung (Thermosonicbonden) oder mittels Ultraschall (Ultrasonicbonden) erfolgen, wobei der Vorteil des Ultraschall gestützten Drahtbondens darin besteht, dass eine Bondverbindung bei Raumtemperatur erzeugt werden kann, wobei bei Golddrähten für Raumtemperaturbonden spezielle Voraussetzungen erfüllt sein müssen. Eine der Voraussetzungen ist zum Beispiel das Coating der Golddrähte mit Aluminium. Das Aluminium, das sich in Inseln abscheidet, oxidiert zu Aluminiumoxid. Beim Bondprozess dient diese Beschichtung als abrasives Medium das durch einen Schmirgeleffekt den Raumtemperaturbondprozess begünstigt.
Löten ist ein thermisches Verfahren zum stoffschlüssigen Fügen von Werkstoffen, wobei eine flüssige Phase durch Schmelzen eines Lotes (Schmelzlöten) entsteht. Beim Löten wird die Solidustemperatur der Grundwerkstoffe nicht erreicht. Das Lotmaterial ist eine leicht schmelzbare Metalllegierung, mit dessen Hilfe eine metallische Verbindung von zwei metallischen Bauteilen erzeugt wird. An der Verbindungsstelle bildet das Lot mit den zu verbindenden Werkstoffen eine oder mehrere intermetallische Phasen aus, die eine feste Verbindung der miteinander zu verbindenden Materialien erzeugt.

Um eine Verbindung zwischen der ersten Metallisierung (im Folgenden auch als Metallschicht bezeichnet) und dem Drahtleiter herzustellen, werden derzeit bei der LTCC-Technologie zwei verschiedene Metallisierungstypen verwendet. Die erste Variante ist ein reines Goldsystem, wobei reine Goldpasten ergänzt mit lötbaren Gemischen (AuPtPd u.Ä.) zum Drucken verwendet werden. Dieses ist jedoch sehr kostenaufwendig. Das zweite System wird als sogenanntes Mixed-Metal-System bezeichnet, das je nach Verwendungszweck neben reinen Silberpasten eine Reihe von silberhaltigen Pastengemischen enthält.

Liegen das Goldpad und die Silber enthaltende Metallisierung übereinander, besteht das Problem, dass die Edelmetalle Gold und Silber, die unterschiedliche Diffusionsgeschwindigkeiten aufweisen, unmittelbar in Kontakt kommen, so dass bei der Diffusion beider Edelmetalle ineinander eine Volumenänderung entsteht, die eine Hohlraumbildung (sogenanntes Kirkendall-Voiding) verursacht. Die Hohlraumbildung kann zu einer Schadhaftigkeit des Übergangs und somit einer Unterbrechung der elektrischen Verbindung führen, die bei allen insbesondere bei in der Medizintechnik verwendeten Substraten nicht toleriert werden kann.

Bisher wird deshalb ein derartiger Übergang meist durch sogenannte Transition-Vias (Durchkontaktierungen) aus einer AgPd-Legierung realisiert, die aber aufgrund einer Fehlpassung zum Tape durch das Sintern zu einem pilzähnlichen Herauswachsen aus dem Tape neigen.

Eine Lösung des oben beschriebenen Problems würde die Aufbringung einer Diffusionssperrschicht zwischen dem Goldpad und der Silbermetallisierung mittels eines global über das gesamte keramische Substrat wirkende Plattierverfahren auf plattierbarem Silber als erste Metallschicht darstellen. Plattieren ist ein stromloses Abscheiden eines Materials auf einem anderen. Ein derartiger Plattierprozess erfordert jedoch einen hohen zeitlichen Aufwand bei der Entwicklung des Prozesses für die konkrete Anwendung. Zudem ist der Prozess sehr fehleranfällig. Insbesondere für medizinische Anwendungen müssen die Substratstrukturen - und hierbei insbesondere die Verbindungen - fehlerfrei arbeiten. Zudem besteht beim Plattieren das Problem, das die für das Plattieren verwendeten Bäder kontinuierlich belastet werden müssen, um eine dauernde Veränderung in ihrer Zusammensetzung (Umschlagen) zu vermeiden. Für kleinere Betriebe ist daher eine Fertigungslinie, die ein Plattierungsschritt beinhaltet, sehr aufwendig. Der integrale Plattierungs-Prozess ist daher für das Aufbringen der Diffusionssperrschicht bei kleinen Durchsätzen nicht geeignet.

Aus der Druckschrift WO 2007/140463 A2 ist ein Verfahren für ein Ink-Jet-Drucken eines lötbaren Kontaktelements auf einem Substrat für die Herstellung von PCB (Printed Circuit Boards) bekannt. Bei PCBs werden die Abdeckmaske und andere Strukturen auf das fertig gestellte Substrat aufgedruckt. Um ein Kontaktelement herzustellen, wird bei dem bekannten Verfahren zunächst eine erste Schicht mit einer ersten Tinte auf ein Substrat aufgebracht, wobei die erste Tinte eine relativ hohe Leitfähigkeit aufweist. Diese erste Schicht wird anschließend einer thermischen Behandlung unterzogen. Anschließend wird eine Zwischenschicht mit einer niedrigen Leitfähigkeit aufgebracht und anschließend ebenfalls einer thermischen Behandlung unterzogen. Schließlich wird auf die Zwischenschicht eine zweite Tinte aufgebracht, die anschließend ebenfalls thermisch behandelt wird. Die dritte Schicht dient zur Herstellung der Lötverbindung.

Die Aufgabe der vorliegenden Erfindung besteht demnach darin, eine LTCC-Substratstruktur anzugeben, welche ein zuverlässiges Kontaktelement aufweist, das die Anwendung des Plattierungsverfahrens überflüssig macht oder zumindest minimiert. Die Aufgabe besteht ferner darin, ein einfaches und kostengünstiges Verfahren zur Herstellung einer LTCC-Substratstruktur anzugeben.

Die obige Aufgabe wird durch eine LTCC-Substratstruktur gelöst, bei der eine die erste Metallisierung oder Metallschicht überdeckende Diffusionssperrschicht, welche mit einem lokal wirkenden Aufbringungsverfahren hergestellt ist, und eine auf der Diffusionssperrschicht angeordnete zweite Metallschicht vorgesehen sind, wobei die zweite Metallschicht vorzugsweise Gold und/oder Platin und/oder eine Legierung enthält, die mindestens eines dieser Elemente aufweist und drahtbondbar ist. Drahtbondbar bedeutet, dass nach MIL 883 ausreichende Bondhaftungen (z.B. 4,5 cN im Mittel) erreicht werden. Die Bondhaftung erfolgt je nach Schichtdicke und Material der Diffusionssperrschicht entweder auf der zweiten Metallschicht (Gold und/oder Platin), möglicherweise aber auch auf der Diffusionssperrschicht.

Der Vorteil einer erfindungsgemäßen Substratstruktur besteht darin, eine Diffusionssperrschicht lokal so exakt zu applizieren, dass ein anschließendes Aufbringen einer zweiten Metallschicht ermöglicht wird. Der Vorteil der erfindungsgemäßen Lösung liegt in der Vermeidung von Transition-Vias, die zum pilzähnlichen Herauswachsen in der Mixed-Metal-Technologie neigen. Zudem kann die Anwendung der fehleranfälligen Plattierungstechnologie vermieden oder auf einen niedrigen Anteil reduziert werden. Auf eine Diffusionssperrschicht kann dann mit beliebigen lokalen oder integralen Verfahren eine weitere, zweite Metallschicht aufgebracht werden.

Vorzugsweise enthält die Diffusionssperrschicht Nickel und/oder eine Nickellegierung. Dies ist ein häufig verwendetes, bewährtes Metall, das zudem preisgünstig ist und in der Sintertemperatur etwa der benötigten Einbrenntemperatur entspricht. Alternativ oder zusätzlich kann die Diffusionssperrschicht eines oder mehrere Elemente aus der Gruppe Titan, Kobalt, Chrom, Wolfram, Molybdän enthalten.

In einem besonders bevorzugten Ausführungsbeispiel ist die Diffusionssperrschicht mittels Drucken hergestellt. Dieses Verfahren eignet sich jedoch lediglich für ebene Substrate ohne Kavitäten (Cavities), da der oben beschriebene Prozess ein sogenannter Postfire-Prozess ist und damit in Kavitäten, die nach dem Sintern bereits vollständig ausgebildet sind, ein Drucken nicht mehr möglich ist.

Um auch in Kavitäten ein erfindungsgemäßes Kontaktelement realisieren zu können, eignen sich für das lokale Aufbringen der entsprechenden Schichten ein Dispensen einer Paste oder Tinte oder ein Ink-Jet-Verfahren (auch als Jetten bezeichnet, lokales Tintenstrahldruck-ähnliches Verfahren unter Verwendung geeigneter Tinten). Gegebenenfalls ist nach dem Aufbringen der Diffusionssperrschicht je nach Beschaffenheit der Paste oder Tinte sowie der Dicke der aufgebrachten Schicht ein Temperschritt notwendig.

Weiterhin hat sich im Zusammenhang mit dem Aufbringen der entsprechenden Schichten das Aerosol-Druck-, Aerosol-Print- oder Aerosol-Jet-Verfahren als besonders vorteilhaft herausgestellt. Das heißt, die Diffusionssperrschicht und/oder die zweite Metallschicht der Substratstruktur ist mittels Aerosol-Druck, Aerosol-Print oder Aerosol-Jet hergestellt Das Verfahren unterscheidet sich zum Ink-Jetten (ähnlich einem Tintenstrahldruck-verfahren) grundsätzlich und ähnelt etwas einem Airbrush-Verfahren. Die verwendeten Pasten können aus den Siebdruckpasten - teilweise durch Verdünnen - erstellt werden und müssen nicht als Ink-Jet-Tinten entwickelt werden.

In einem weiteren Ausführungsbeispiel ist die zweite Metallschicht mittels Plattieren hergestellt. Aufgrund der chemischen Spannungsreihe ist ein derartiger Schritt auf einer Diffusionssperrschicht ohne spezielle Vorbehandlungsschritte möglich (im Gegensatz zu einer Abscheidung von unedlem Nickel auf einer edlen Silberschicht).

In weiteren Ausführungsbeispielen ist die zweite Metallschicht mittels Drucken oder Dispensen einer Paste oder Jetten hergestellt. Die Aufbringung kann auch durch weitere geeignete und bekannte Druck- oder Schreibverfahren erfolgen.

Die obige Aufgabenstellung wird ferner durch ein Verfahren zur Herstellung einer oben angegebenen LTCC-Substratstruktur gelöst, bei dem
- zunächst die Substratstruktur mit Kontaktelement bereitgestellt wird, wobei das Kontaktelement die erste, auf und/oder in dem keramischen Substrat angeordnete Metallschicht oder Metallisierung aufweist,
- anschließend die erste Metallschicht oder Metallisierung mit der Diffusionssperrschicht mittels eines lokal wirkenden Aufbringungsverfahrens überdeckt wird und
- danach auf der Diffusionssperrschicht die zweite Metallschicht angeordnet wird.

Ein derartiges Herstellungsverfahren erlaubt die Realisierung einer Vielzahl von Layouts, die bisher aus reinem Gold gefertigt werden müssen, insbesondere für Anwendungen aus der Medizintechnik, da sichere Kontaktelemente erzeugt werden. Zudem gelten die obigen, im Zusammenhang mit der Leiterplatte genannten Vorteile auch für das erfindungsgemäße Verfahren.

In einem Ausführungsbeispiel des erfindungsgemäßen Verfahrens wird die Diffusionssperrschicht mittels Drucken aufgebracht und anschließend, vor dem Aufbringen der zweiten Metallschicht, ein Temperschritt durchgeführt. Bevorzugt wird die zweite Metallschicht mittels Drucken mit einem nachfolgenden Temperschritt oder mittels Plattieren aufgebracht. Die Diffusionssperrschicht und/oder die zweite Metallschicht können auch mittels Jetten oder Dispensen einer Paste aufgebracht werden. Besonders bevorzugt können die Diffusionssperrschicht und/oder die zweite Metallschicht mittels Aerosol-Druck, Aerosol-Print oder Aerosol-Jet einer Paste oder Tinte aufgebracht werden.

Bevorzugt kann nach dem Aufbringen der zweiten Metallschicht ein weiterer Temperschritt durchgeführt werden.

Weitere Ziele, Merkmale, Vorteile und Anwendungsmöglichkeiten der Erfindung ergeben sich aus der nachfolgenden Beschreibung eines Ausführungsbeispiels. Alle beschriebenen und/oder bildlich dargestellten Merkmale bilden für sich oder in beliebiger Kombination den Gegenstand der vorliegenden Erfindung, unabhängig von ihrer Zusammenfassung in den einzelnen Ansprüchen oder deren Rückbeziehung.

Es zeigen schematisch:
- Fig. 1: einen Querschnitt durch ein erstes Ausführungsbeispiel einer erfindungsgemäßen Substratstruktur,
- Fig. 2: einen Querschnitt eines zweiten Ausführungsbeispiels einer erfindungsgemäßen Substratstruktur,
- Fig. 3: einen Verfahrensschritt zur Herstellung des Ausführungsbeispiels gemäß Fig. 1 und
- Fig. 4: einen alternativen Verfahrensschritt zur Herstellung des Ausführungsbeispiels gemäß Fig. 1.

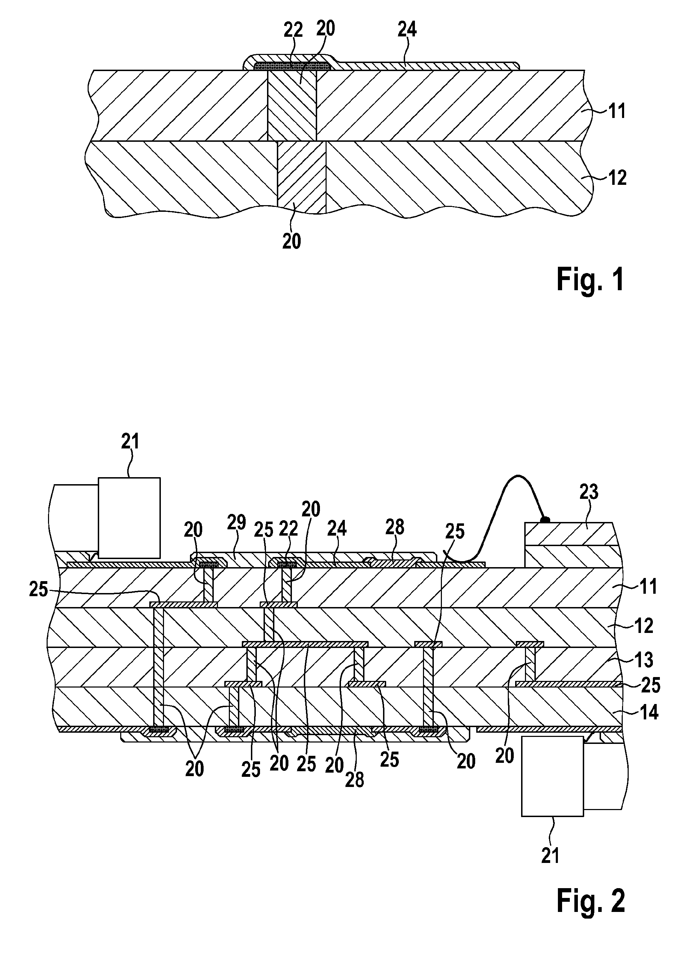

Das erste Ausführungsbeispiel in Fig. 1 zeigt zwei übereinander liegende Substratschichten 11, 12, die mittels LTCC hergestellt wurden. Durch die erste Schicht 11 und die zweite Schicht 12 der erfindungsgemäßen Substratstruktur verlaufen erste Metallisierungen in Form von Silber-Durchkontaktierungen (Ag-Via) 20, welche die darunter liegende Leiterstrukturen mit den auf der Oberfläche der Substratstruktur angeordneten Leiterstrukturen bzw. Bauelementen verbinden. Die Durchkontaktierungen 20 sind im Wesentlichen zylindrisch ausgebildet, wobei die durch die Substratschicht 11 verlaufende Durchkontaktierung 20 einen Teil der oben liegenden Oberfläche der Substratstruktur ausbildet.

Auf der in der oberen Substratschicht 11 verlaufenden Durchkontaktierung 20 ist eine Diffusionssperrschicht (im Folgenden auch Passivierungsschicht genannt) 22 angeordnet, welche Nickel und/oder eine Nickellegierung enthält. Diese wird mittels Drucken oder Dispensen einer Paste oder Jetten lokal aufgetragen. Die Diffusionssperrschicht deckt den an der Oberfläche der Substratschicht 11 liegenden Bereich der Durchkontaktierung 20 vollständig ab und überdeckt auch die angrenzenden Bereiche des Substrats 11.

Die Diffusionssperrschicht 22 wird vollständig durch eine darüber liegende zweite Metallschicht 24 bedeckt und abgedeckt, welche Gold und/oder Platin und/oder eine Legierung mit Gold und/oder Platin enthält. Die zweite Metallschicht 24 ist drahtbondbar ausgebildet.

Bei dem in Fig. 2 dargestellten zweiten Ausführungsbeispiel einer erfindungsgemäßen Substratstruktur, liegen vier LTCC-Schichten 11, 12, 13, 14 in dieser Reihenfolge übereinander. Zwischen den Schichten sind Leiterstrukturen 25 (beispielsweise aus Silber) angeordnet, welche auch als Leiterzüge bezeichnet werden. Jeder Leiterzug 25 ist mittels Durchkontaktierungen 20 entweder mit der Oberfläche der Schicht 11 oder der Schicht 14 oder mit einem weiteren Leiterzug 25 verbunden. Alle Durchkontaktierungen 20 enthalten Silber und/oder eine Silberlegierung.

An der Oberseite (Oberfläche) der Schicht 11 bzw. der Unterseite (Oberfläche) der Schicht 14 sind die Silber-Durchkontaktierungen 20 mit jeweils einer Diffusionssperrschicht 22 sowie jeweils einer darüber liegenden, die Passivierungsschicht 22 vollständig bedeckenden, zweiten Metallschicht 24 versehen, wobei die zweite Metallschicht 24 eine Gold und/oder Platin enthaltenden Legierung enthält. Die zweite Metallschicht 24 ist ggf. mit einem auf der Oberseite der Schicht 11 angeordneten Widerstand 28 verbunden. Um einen weitergehenden Schutz zu gewährleisten, sind die Widerstände 28 mittels einer Glaspassivierung 29 geschützt.

Auf der Oberseite und Unterseite des Substrates können weitere Strukturen befestigt sein. In Fig. 2 sind aktive bzw. passive Bauteile 21 sowie ein Chip 23 dargestellt. Diese Bauteile sind entweder auf das Substrat geklebt oder gelötet oder aber an das Substrat gebondet.

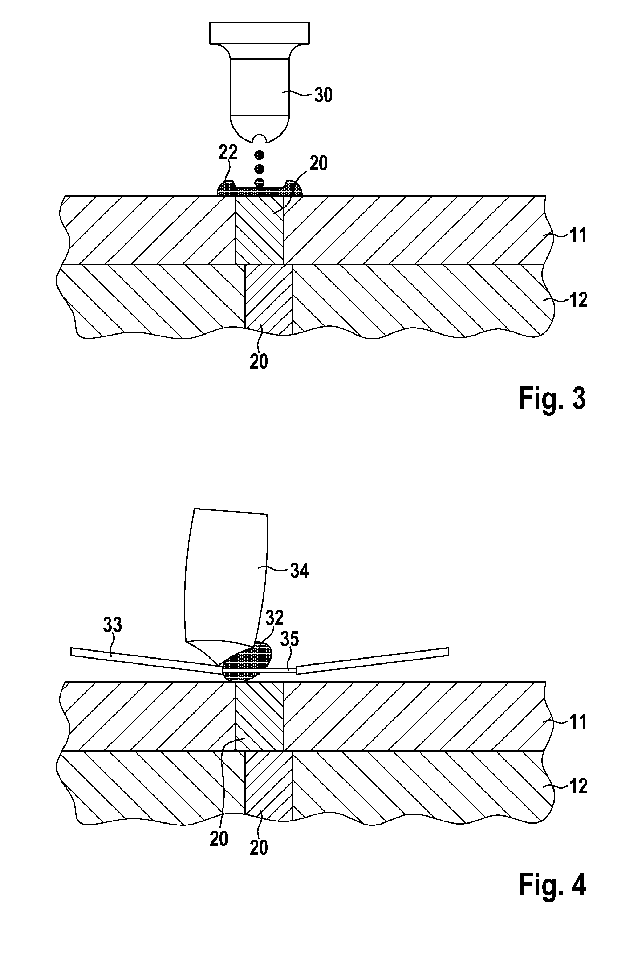

In Fig. 3 ist gezeigt, wie die Diffusionssperrschicht 22 hergestellt wird. Bei dem dargestellten Verfahren wird die Diffusionssperrschicht 22 mittels eines Dispensers oder Inkjetdüse 30 in flüssigem Zustand auf die Oberfläche der ersten Substratschicht 11 aufgetragen, und zwar dort, wo die Durchkontaktierung 20 angeordnet ist und einen Teil der Oberfläche bildet. Bei der Diffusionssperrschicht kann es sich beispielsweise um eine nickelmetallhaltige Tinte oder eine niedrigviskose Paste handeln. Hierbei wird das Material der Diffusionssperrschicht an dem Ort und in der Menge aufgetragen, dass der durch die Durchkontaktierung 20 gebildete Bereich der Oberfläche der ersten Substratschicht 11 vollständig abgedeckt wird.

Bei dem in Fig. 4 dargestellten Ausführungsbeispiel, welches eine Alternative zu dem Ausführungsbeispiel gemäß Fig. 3 bildet, wird zur Herstellung einer Diffusionssperrschicht 22 ein Sieb 33 auf die Oberfläche der ersten Schicht 11 mit Durchkontaktierung 20 gelegt. Anschließend wird beispielsweise eine nickelmetallhaltige Siebdruckpaste 32 für die Diffusionssperrschicht auf das Sieb 33 aufgetragen. Mittels eines Rakels 34 wird die nickelmetallhaltige Siebdruckpaste 32 auf dem Sieb 33 verteilt. Das Sieb 33 weist in dem Bereich, in dem die Durchkontaktierung 20 einen Teil der Oberfläche der ersten Schicht ausbildet, eine Öffnung in der beschichteten Emulsion auf dem Sieb 35 auf, so dass in diesem Bereich die Siebdruckpaste 32 auf die Oberfläche der ersten Schicht 11 mit Durchkontaktierung 20 aufgetragen wird.

Wird der Druck mittels eines Aerosol-Druck-Verfahrens durchgeführt, verläuft das Verfahren dergestalt, dass die verdünnten Pasten oder Tinten in einem Zerstäubermodul in ein dichtes Aerosol mit einer Tröpfchengröße von 1 bis 5 µm zerlegt werden. Dazu kommen je nach Viskosität der Pasten ein pneumatisches Zerstäubermodul (1-1000 mPas) oder ein Ultraschallzerstäuber (0,1-30 mPas). Das Aerosol wird von einem inerten Gasstrom zu einem Beschichtungskopf geführt und von einem Umhüllungsgasstrom aerodynamisch fokussiert. Über eine Düse erfolgt die Abscheidung auf dem Substrat. Die Druckauflösung reicht von 10 µm bis 5 mm Strukturbreite. Durch Mehrfachdruck kann eine Schichtdicke von bis zu 10 µm erzeugt werden. Optional ist unmittelbar nach dem Druck ein lokaler Pasteneinbrand durch einen Laser möglich.

Im Anschluss an das Aufbringen der Diffusionssperrschicht 22 wird diese einer Temperaturbehandlung (Temperschritt) unterzogen. Der Einbrand beziehungsweise der Temperschritt erfolgt entweder an Luft oder unter einer Schutzgasatmosphäre, die eine Oxidation des Metalls verhindert. Dabei herrschen je nach Pastentyp und Korngröße des Metallpulvers in der Paste Temperaturen zwischen 500°C und 875°C.

### Bezugszeichenliste:

- 11: erste Substratschicht/LTCC-Schicht
- 12: zweite Substratschicht/LTCC-Schicht
- 13, 14: weitere Substratschichten/LTCC-Schichten
- 20: Durchkontaktierung, Via
- 21: aktives oder passives Bauteil
- 22: Diffusionssperrschicht,
- 23: Chip
- 24: zweite Metallschicht
- 25: Leiterzug
- 28: Widerstand
- 29: Glaspassivierung
- 30: Dispenser, Inkjet Düse
- 32: Siebdruck-Paste
- 33: Sieb
- 34: Rakel
- 35: Öffnung in der beschichteten Emulsion auf dem Sieb (Strukturierung)

## Patentansprüche

1. LTCC-Substratstruktur mit mindestens einem Kontaktelement zum Anschluss eines Drahtleiters, das eine erste, auf und/oder in dem keramischen Substrat angeordnete Metallisierung (20) zur elektrischen Verbindung mit dem Drahtleiter aufweist, wobei die erste Metallisierung (20) vorzugsweise Silber oder eine Silberlegierung enthält, **dadurch gekennzeichnet, dass** eine die erste Metallisierung (20) überdeckende Diffusionssperrschicht (22), welche mit einem lokal wirkenden Aufbringungsverfahren hergestellt ist, und eine auf der Diffusionssperrschicht (22) angeordnete zweite Metallschicht (24) vorgesehen sind, wobei die zweite Metallschicht vorzugsweise Gold und/oder Platin und/oder eine Legierung enthält, die mindestens eines dieser Elemente aufweist.

2. Substratstruktur nach Anspruch 1, **dadurch gekennzeichnet, dass** die Diffusionssperrschicht (22) Nickel und/oder eine Nickellegierung enthält.

3. Substratstruktur nach einem der vorhergehenden Ansprüche, **dadurch gekennzeichnet, dass** das lokal wirkende Aufbringungsverfahren zur Herstellung der Diffusionssperrschicht (22) das Drucken oder das Dispensen einer Paste oder das Jetten ist.

4. Substratstruktur nach einem der vorhergehenden Ansprüche, **dadurch gekennzeichnet, dass** die zweite Metallschicht (24) mittels Drucken oder Dispensen einer Paste oder Jetten oder Plattieren hergestellt ist.

5. Substratstruktur nach einem der vorhergehenden Ansprüche, **dadurch gekennzeichnet, dass** die Diffusionssperrschicht (22) und/oder die zweite Metallschicht (24) mittels Aerosol-Druck, Aerosol-Print oder Aerosol-Jet hergestellt ist.

6. Verfahren zur Herstellung einer LTCC-Substratstruktur nach Anspruch 1, **dadurch gekennzeichnet, dass**
- zunächst die Substratstruktur mit Kontaktelement bereitgestellt wird, wobei das Kontaktelement die erste, auf und/oder in dem keramischen Substrat angeordnete Metallisierung (20) aufweist,
- anschließend die erste Metallisierung (20) mit der Diffusionssperrschicht (22) mittels eines lokal wirkenden Aufbringungsverfahrens überdeckt wird und
- danach auf der Diffusionssperrschicht (22) die zweite Metallschicht (24) angeordnet wird.

7. Verfahren nach Anspruch 6, **dadurch gekennzeichnet, dass** die Diffusionssperrschicht (22) mittels Drucken aufgebracht wird und anschließend, vor dem Aufbringen der zweiten Metallschicht (24), ein Temperschritt durchgeführt wird.

8. Verfahren nach einem der Ansprüche 6 oder 7, **dadurch gekennzeichnet, dass** die zweite Metallschicht (24) mittels Drucken mit einem nachfolgenden Temperschritt oder mittels Plattieren aufgebracht wird.

9. Verfahren nach einem der Ansprüche 6 bis 8, **dadurch gekennzeichnet, dass** die Diffusionssperrschicht (22) und/oder die zweite Metallschicht (24) mittels Jetten oder Dispensen einer Paste aufgebracht werden.

10. Verfahren nach einem der Ansprüche 6 bis 9, **dadurch gekennzeichnet, dass** die Diffusionssperrschicht (22) und/oder die zweite Metallschicht (24) mittels Aerosol-Druck, Aerosol-Print oder Aerosol-Jet einer Paste oder Tinte aufgebracht werden.

11. Verfahren nach einem der Ansprüche 6 bis 10, **dadurch gekennzeichnet, dass** nach dem Aufbringen der zweiten Metallschicht (24) ein Temperschritt durchgeführt wird.
